(19) Europäisches Patentamt / European Patent Office / Office européen des brevets

(11) **EP 2 513 660 B1**

(12) **EUROPÄISCHE PATENTSCHRIFT**

(45) Veröffentlichungstag und Bekanntmachung des Hinweises auf die Patenterteilung:
**13.03.2019 Patentblatt 2019/11**

(21) Anmeldenummer: **10775779.1**

(22) Anmeldetag: **28.10.2010**

(51) Int Cl.:
**G01R 31/36** (2019.01)   **G01R 27/14** (2006.01)

(86) Internationale Anmeldenummer:
**PCT/EP2010/066354**

(87) Internationale Veröffentlichungsnummer:
**WO 2011/072939 (23.06.2011 Gazette 2011/25)**

(54) **VERFAHREN ZUR ERMITTLUNG VON KONTAKT- UND VERBINDERWIDERSTÄNDEN IN EINEM BATTERIEPACK UND BATTERIESYSTEM ZUR ERMITTLUNG VON KONTAKT- UND VERBINDERWIDERSTÄNDEN IN EINEM BATTERIEPACK**

METHOD FOR DETERMINING CONTACT AND CONNECTOR RESISTANCES IN A BATTERY PACK AND BATTERY SYSTEM FOR DETERMINING CONTACT AND CONNECTOR RESISTANCES IN A BATTERY PACK

PROCÉDÉ PERMETTANT DE DÉTERMINER LA RÉSISTANCE DES CONTACTS ET DES CONNECTEURS DANS UN BLOC-BATTERIE ET SYSTÈME DE BATTERIE PERMETTANT DE DÉTERMINER LA RÉSISTANCE DES CONTACTS ET DES CONNECTEURS DANS UN BLOC-BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2009 DE 102009054937**

(43) Veröffentlichungstag der Anmeldung:
**24.10.2012 Patentblatt 2012/43**

(73) Patentinhaber:
• **Samsung SDI Co., Ltd.**
  **Gyeonggi-do (KR)**
• **Robert Bosch GmbH**
  **70442 Stuttgart (DE)**

(72) Erfinder:
• **BOEHM, Andre**
  **70806 Kornwestheim (DE)**
• **ANGERBAUER, Ralf**
  **71696 Möglingen (DE)**

(74) Vertreter: **Bee, Joachim et al**
  **Robert Bosch GmbH**
  **Zentralabteilung Patente**
  **Postfach 30 02 20**
  **70442 Stuttgart (DE)**

(56) Entgegenhaltungen:

US-A- 4 697 134     US-A- 5 744 962
US-A- 5 969 625     US-A1- 2002 180 445
US-A1- 2009 035 658

• SOILEAU R D JR: "A diagnostic testing program for large lead acid storage battery banks", PETROLEUM AND CHEMICAL INDUSTRY CONFERENCE, 1992, RECORD OF CONFERENCE PAPERS., INDUSTRY APPLICATIONS SOCIETY 39TH ANNUAL SAN ANTONIO, TX, USA 28-30 SEPT. 1992, NEW YORK, NY, USA,IEEE, US, 28. September 1992 (1992-09-28), Seiten 27-35, XP010066583, DOI: DOI:10.1109/PCICON.1992.229330 ISBN: 978-0-7803-0750-6
• BOSE C S C ET AL: "Lessons learned in using ohmic techniques for battery monitoring", APPLICATIONS AND ADVANCES, 2001. THE SIXTEENTH ANNUAL BATTERY CONFEREN CE ON 9-12 JANUARY 2001, PISCATAWAY, NJ, USA,IEEE, 9. Januar 2001 (2001-01-09), Seiten 99-104, XP010532835, ISBN: 978-0-7803-6545-2
• "IEEE Recommended Practice for Maintenance, Testing, and Replacement of Valve-Regulated Lead-Acid (VRLA) Batteries for Stationary Applications;IEEE Std 1188-1996", IEEE STANDARD, IEEE, PISCATAWAY, NJ, USA, 1. Januar 1996 (1996-01-01), Seite I, XP017602997, ISBN: 978-1-55937-747-8

**Beschreibung**

Stand der Technik

Die Erfindung geht aus von einem Verfahren zur Ermittlung von Kontakt- und Verbinderwiderständen in einem Batteriepack bestehend aus N elektrochemischen Einzelzellen. Gegenstand der vorliegenden Erfindung sind auch ein Batteriesystem bestehend aus einem Li-Ionenbatteriepack und einem Batteriemanagementsystem, welches nach obigen Verfahren arbeitet sowie ein Kraftfahrzeug, welches ein Batteriesystem bestehend aus einem Li-Ionenbatteriepack und ein entsprechendes Batteriemanagementsystem beinhaltet. Ferner ist ein Computerprogramm Gegenstand der Erfindung, das alle Schritte des erfindungsgemäßen Verfahrens ausführt, wenn es auf einem Rechengerät abläuft.

In vielfältigen Anwendungen, wie z.B. in Hybrid- oder Elektrofahrzeugen oder Notebooks, wird elektrische Energie, die in einer Batterie gespeichert ist, als Energiequelle verwendet. In den Batteriepacks werden elektrochemische Zellen beispielsweise in Reihe geschaltet, um die Spannungslage an die jeweilige Anwendung anzupassen und ausreichend Energie zur Verfügung zu haben. Stand der Technik findet sich beispielsweise in den Dokumenten US2009/035658 und US4697134.

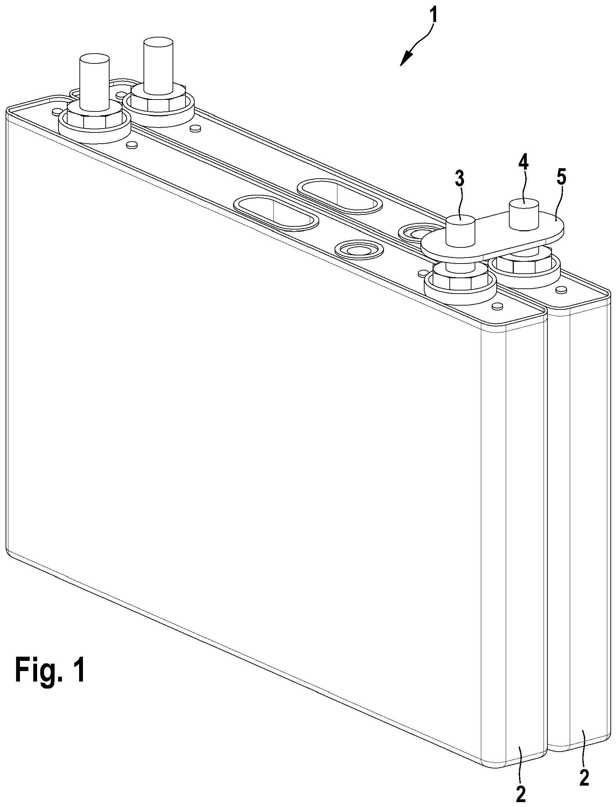

Es ist bekannt, zur Verbindung der Einzelzellen in Batteriepacks mechanische Zellverbinder zu verwenden, die die leitende Verbindung zwischen den Zellen herstellen. Fig. 1 zeigt ein solches Verbindungselement des Standes der Technik. Ein Batteriepack 1 besteht hier aus zwei elektrochemischen Einzelzellen 2. Jede dieser elektrochemischen Einzelzellen 2 umfasst einen negativen Batteriepol 3 und einen positiven Batteriepol 4. Zur Reihenschaltung der Batterien ist z.B. der negative Batteriepol 3 der ersten Einzelzelle 2 mit den positiven Batteriepol 4 der zweiten Einzelzelle 2 über ein Verbindungselement 5 elektrisch leitend verbunden. Ein solches Verbindungselement 5 kann angeschraubt, angeschweißt oder auf andere Art und Weise befestigt werden, woraus weitere elektrische Widerstände resultieren. Durch die Verbindung von zwei Einzelzellen 2 kommen zu den Innenwiderständen der Einzelzellen 2 noch zwei Kontaktwiderstände des Verbindungselementes 5 mit dem Plus- bzw. Minuspol der jeweiligen Zelle 2 hinzu, sowie ein Widerstand aufgrund des Verbindungselementes 5 selbst, auch Verbinderwiderstand genannt. Es ist diese Summe von Kontakt- und Verbinderwiderständen, die bei der Verbindung in Batteriepacks von Interesse ist.

Nach erfolgter Montage ist eine Prüfung der Kontakte zwischen Verbindungselement 5 und den Batteriepolen 3, 4 notwendig, um sicherzustellen, dass alle Verbindungen korrekt ausgeführt wurden. Dies kann auch zu einem späteren Zeitpunkt während des Betriebs sinnvoll sein, um Verschleiß aufspüren zu können. Durch mechanische Belastungen, wie z. B. durch Schwingungen beim Betrieb eines mittels Zellverbindern gekoppelten Batteriepacks insbesondere in einem Fahrzeug kann es zu Ablösungen bzw. Abstandsvergrößerungen zwischen den Kontaktstellen des Zellverbinders kommen, was sich weiter widerstandserhöhend auswirkt.

In der Batterietechnik wird zu diesem Zweck in der Regel ein Gleichstrom auf das verbundene Pack oder Modul eingeprägt und die Spannungsabfälle an den Verbindern gemessen. Nachteiligerweise führt dies allerdings zur Entladung oder Ladung der Zellen während der Prüfung. Ferner ist die maximale Untersuchungsdauer durch die Ladung und Aufladung eingeschränkt. Es ist zudem eine Spannungsüberwachung zum Schutz vor Über- oder Unterladung notwendig. Weiter ist nachteilig, dass ein hoher Innenwiderstand der Zellen bei Gleichstrom die Genauigkeit der Messung der niederohmigen Verbindung reduziert.

Offenbarung der Erfindung

Erfindungsgemäß wird ein Verfahren zur Ermittlung von Kontakt- und Verbinderwiderständen in einem Batteriepack angegeben, welches aus einer Mehrzahl von N miteinander verbundener einzelner elektrochemischer Batteriezellen besteht, umfassend die Schritte der Kontaktierung zweier Einzelzellen des Batteriepacks, Einprägung eines Wechselstromes $I(j\omega)$ bei einer Untersuchungsfrequenz $\omega$ auf die Kontakte, Messung der Spannungsabfälle $U(j\omega)$ zwischen den Kontakten, und Berechnung der Kontakt- und Verbinderwiderstände aus eingeprägtem Strom $I(j\omega)$ und gemessenem Spannungsabfall $U(j\omega)$ durch die folgenden Schritte: Ermittlung des Messwiderstandes $R_{mess}(j\omega)$ aus dem gemessenen Spannungsabfall $U(j\omega)$ und dem eingeprägten Strom $I(j\omega)$ mittels des ohmschen Gesetzes, und Ermittlung der Summe aus Kontakt- und Verbinderwiderständen $R_{kon\text{-}takt/verbinder}(j\omega)$ mittels Subtraktion der Summe der vorgegebenen Innenwiderstände $R_{zelle}(j\omega)$ der Einzelzellen, über denen gemessen wurde, von dem ermittelten Messwiderstand $R_{mess}(j\omega)$ gemäß der Gleichung:

$$R_{kontakt/verbinder}(j\omega) = R_{mess}(j\omega) - R_{zelle}(j\omega) *M,$$

wobei der ohmsche Widerstand $R_{zelle}$ der M Zellen, über denen gemessen wurde, vorbekannt ist.

Das Verfahren stellt dabei vorteilhafterweise eine günstige und präzise Methode zur Vermessung der Kontakt- und Verbinderwiderstände in Batteriepacks bzw. - modulen dar, die eine schnellere Bandendabnahme nach Zusammenfügung des Batteriepacks ermöglicht, aber auch beispielsweise eine Messung in einem Fahrzeug, in dem das Batteriepack eingebaut ist, über ein im Fahrzeug angeordnetes Batteriemanagementsystem.

Das erfindungsgemäße Verfahren mit den Merkmalen des unabhängigen Anspruchs hat gegenüber dem Stand der Technik den Vorteil, dass die Vermessung des Innenwiderstands eines Batteriemoduls oder -packs mit Hilfe eines Wechselstroms eine unbegrenzte Messdauer aufgrund der Ladungsneutralität der Untersuchung ermöglicht. Ferner ist keine Spannungsüberwachung der Einzelzellen notwendig.

Erfindungsgemäß ist die Untersuchungsfrequenz $\omega$ die Resonanzfrequenz, die sich dadurch auszeichnet, dass bei ihr die Impedanz rein ohmsch bzw. reell ohne ginärteil ist. Vorteilhafterweise erfolgt die Messung dadurch bei geringem Wechselstromwiderstand der Zellen, so dass im Verhältnis die zu messende Summe aus Kontakt- und Verbinderwiderständen verbessert bestimmbar ist. Es können kapazitive oder induktive Anteile der Verbindungsimpedanz mitbestimmt werden.

Die Subtraktion der Summe der bekannten Innenwiderstände ermöglicht dabei eine Angabe der Größe der Kontakt- und Verbinderwiderstände in einem Batteriepack bestehend aus mehreren elektrochemischen Einzelzellen.

Die Messung kann zwischen zwei benachbarten Zellen eines Batteriepacks erfolgen. Sind die beiden benachbarten Zellen durch ein Verbindungselement verbunden, wird demnach die Summe aus zwei Kontaktwiderständen und einem Verbinderwiderstand ermittelt.

Erfindungsgemäß erfolgt die Messung über dem gesamten Batteriepack durch Kontaktierung der ersten und letzten Einzelzelle des Batteriepacks. Dies ermöglicht eine Reduktion des Messaufwands. Zudem haben statistischen Schwankungen durch Messung über alle Zellen eine geringere Auswirkung auf die Ermittlung der Kontakt- und Verbinderwiderstände als bei Messung über zwei Einzelzellen. Es wird zunächst die Gesamtimpedanz $R_{ges}(j\omega)$ berechnet aus $R_{ges}(j\omega) = U(j\omega)/I(j\omega)$. Danach wird die Summe aus Kontakt- und Verbinderwiderständen mittels Abzug des ohmschen Widerstandes $R_{zelle}$ der N Zellen des Batteriepacks bei der Untersuchungsfrequenz $\omega$ ermittelt. Es gilt dann:

$$R_{Kontakt/verbinder}(j\omega) = R_{ges}(j\omega) - R_{zelle}(j\omega) *N,$$

wobei der ohmsche Widerstand $R_{zelle}$ der N Zellen vorbekannt ist, z.B. aus dem Datenblatt der einzelnen elektrochemischen Batteriezellen. Der aus dem Datenblatt der Einzelzellen bekannte Wert ist üblicherweise im Vorfeld statistisch ermittelt.

Die Untersuchungsfrequenz liegt bevorzugt im Bereich von 500 Hz bis 3kHz, noch bevorzugter im Bereich von 1,5kHz bis 3kHz. Bei niedrigeren Frequenzen ist der Widerstand relativ hoch und zeigt kapazitive Anteile.

Entsprechend ist ein Computerprogramm angegeben, welches alle Schritte des erfindungsgemäßen Verfahrens ausführt, wenn es auf einem Rechengerät abläuft.

Ebenso wird ein Batteriemanagementsystem, insbesondere für Li-Ionen Batterien vorgeschlagen, wobei das Batteriesystem das obige Verfahren zur Bestimmung des Ladezustands umfasst.

Entsprechend wird ein Batteriesystem angegeben, welches ein Li-Ionen-Batteriepack bestehend aus einer Mehrzahl von einzelnen Batteriezellen und ein Batteriemanagementsystem für Li-Ionen Batterien umfasst, wobei das Batteriesystem das obige Verfahren zur Bestimmung des Ladezustands umfasst.

Des Weiteren wird ein Kraftfahrzeug angegeben, welches mit einem Antriebssystem ausgerüstet ist, das ein entsprechendes erfindungsgemäßes Batteriesystem umfasst.

Ausführungsbeispiele der Erfindung sind in den Zeichnungen dargestellt und in der nachfolgenden Beschreibung näher erläutert.

Es zeigen:

Figur 1    ein Batteriepack mit einem Verbindungselement des Standes der Technik,

Figur 2    ein Flussdiagramm des erfindungsgemäßen Verfahrens,

Figur 3    charakteristische Impedanzkurven verschiedener elektrochemischer Zellen

Fig. 1 zeigt ein Batteriepack 1 des Standes der Technik, bestehend aus zwei elektrochemischen Einzelzellen 2, die über ein Verbindungselement oder Verbinder 5 verbunden sind. Der Verbinder 5 kontaktiert dabei einen ersten Pol 3 der ersten Einzelzelle und einen zweiten Pol 4 der zweiten Einzelzellen. Durch die Verbindung mit dem Verbinder 5 entstehen zwei Kontaktwiderstände zwischen erstem Pol 3 und Verbinder 5 sowie zweitem Pol 4 und Verbinder 5. Ferner hat der Verbinder 5 selbst einen Widerstand, den sogenannten Verbinderwiderstand. Die Einführung eines Verbinders zwischen zwei Zellen resultiert also in drei zusätzlichen Widerständen, zwei Kontakt- und einem Verbinderwiderstand, die in Summe bestimmt werden können. Die Summe gibt dann einen Hinweis darauf, wie gut die Kontakte hergestellt wurden bzw. ob die Kontakte im Betrieb gealtert sind.

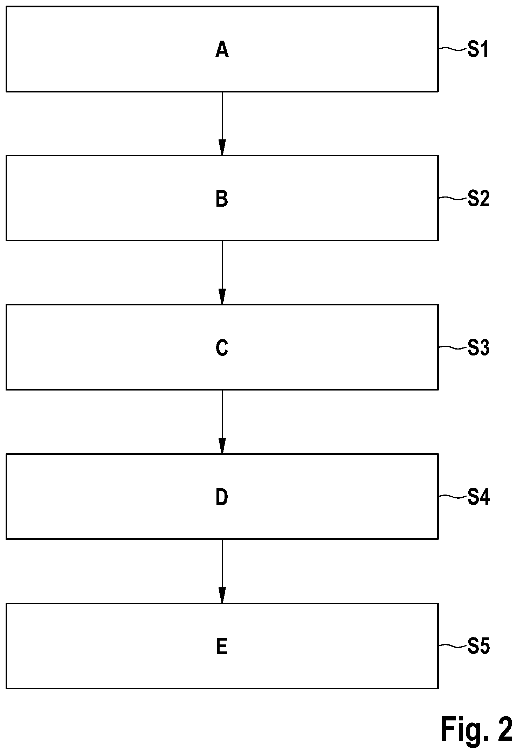

In der Figur 2 ist ein Flussdiagramm des erfindungsgemäßen Verfahrens zur Bestimmung der Summe aus Kontakt- und Verbinderwiderständen in einem Batteriepack gezeigt. Das Batteriepack besteht im Folgenden bevorzugt aus Li-Ionen Batteriezellen, kann aber auch auf andere Batterietypen bestehend aus mehreren elektrochemischen Zellen angewandt werden. In Figur 2 steht der Platzhalter "A" für die "Kontaktierung zweier Einzelzellen", der Platzhalter "B" für die "Einprägung eines Wechselstromes $I(j\omega)$", der Platzhalter "C" für die "Messung der Spannungsabfälle $U(j\omega)$ zwischen den Kontakten", der Plazthalter "D" für "$R_{mess}(j\omega) = U(j\omega)/I(j\omega)$", und der Platzhalter "E" für die Gleichung:

$$R_{kontakt/verbinder}(j\omega) = R_{mess}(j\omega) - R_{zelle}(j\omega)*M.$$

Es wird zunächst im Schritt S1 die Kontaktierung zweier Einzelzellen des Batteriepacks vorgenommen. In einem zweiten Schritt S2 erfolgt eine Einprägung eines Wechselstromes $I(j\omega)$ bei einer Untersuchungsfrequenz $\omega$ auf die Kontakte der beiden kontaktierten Einzelzellen. Im dritten Schritt S3 wird dann Spannungsabfall $U(j\omega)$ zwischen den Kontakten gemessen, und daraus in den Schritten S4 und S5 der resultierende Widerstand aus eingeprägtem Strom $I(j\omega)$ und gemessenem Spannungsabfall $U(j\omega)$ berechnet.

Der Kern der Erfindung liegt somit in der Vermessung des Innenwiderstands eines Batteriemoduls oder -packs mit Hilfe eines Wechselstroms, anstatt eines Gleichstroms.

Im Schritt S4 der Berechnung des resultierenden Widerstandes geht man dann wie folgt vor: Es wird zunächst aus dem eingeprägten Strom $I(j\omega)$ und gemessenem Spannungsabfall $U(j\omega)$ direkt über das ohmsche Gesetz der Messwiderstand berechnet:

$$R_{mess}(j\omega) = U(j\omega)/I(j\omega). \qquad (1)$$

Im Schritt S5 wird dann von diesem Widerstand die Summe der bekannten Innenwiderstände der elektrochemischen Einzelzellen, über denen gemessen wurde, abgezogen:

$$R_{kontakt/verbinder}(j\omega) = R_{mess}(j\omega) - R_{zelle}(j\omega)*M, \qquad (2)$$

wobei M die Anzahl der Zellen ist, über denen gemessen wurde. Werden also die i-te Einzelzelle und die j-te Einzelzelle kontaktiert, ist M=(j-i)+1, wobei i, j Elemente der natürlichen Zahlen sind und j>i.

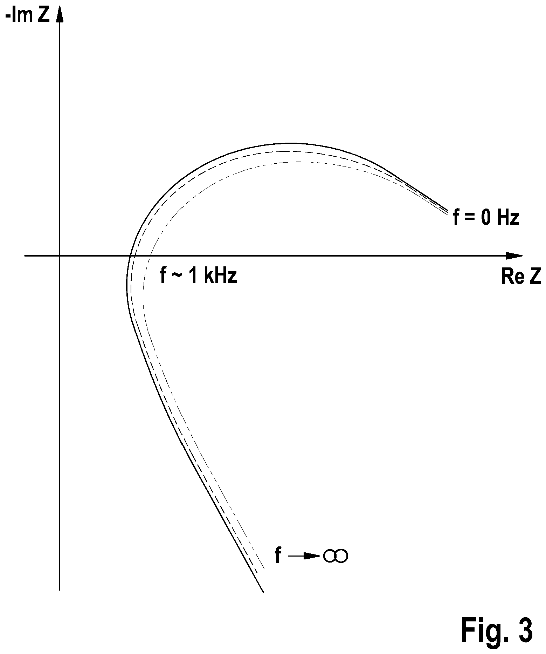

Figur 3 zeigt typische Impedanzkurven dreier elektrochemischer Zellen als komplexe Größe mit einem Realteil "Re Z" und einem Imaginärteil "Im Z". Eingezeichnet sind die Grenzwerte für eine Frequenz von 0 Hz und einer unendlichen Frequenz. Bei niedrigen Frequenzen ist der Widerstand relativ hoch, die Impedanz hat also einen hohen Realteil, und zeigt kapazitive Anteile durch den Imaginärteil der Impedanz Z. Bei einer Resonanzfrequenz die typischerweise im Bereich von etwa 500 Hz bis 3 kHz liegt, im Beispiel der Fig. 4 bei ca. 1kHZ, wird die Impedanz Z rein ohmsch bzw. reell und hat keinen Imaginärteil. Zudem ist der Wechselstromwiderstand bei dieser Resonanzfrequenz minimal und in der Regel um einen Faktor von etwa 2 bis 5 geringer als bei niedrigen Frequenzen.

Die Messung der Kontakt- oder Verbinderwiderstände kann zwischen jeweils zwei benachbarten Zellen erfolgen oder über beliebige Zellen des Batteriepacks.

Besonders bevorzugt sieht das Verfahren die Anregung des ganzen Batteriepacks oder -moduls mit einem Wechselstrom vor, in einer vorteilhaften Ausprägung bei der Resonanzfrequenz der Zellen. Zunächst wird die Gesamtspannung des Packs gemessen und der statistisch ermittelte mittlere Innenwiderstand der Zeilen $R_{zelle}(j\omega)$ bei der Untersuchungsfrequenz $\omega$ abgezogen. Dazu wird die Gesamtimpedanz gemäß:

$$R_{ges}(j\omega) = U(j\omega)/I(j\omega) \qquad (3)$$

berechnet und dann der ohmsche Widerstand der N Zellen bei Resonanzfrequenz abgezogen:

$$R_{Kontakt}(j\omega) = R_{ges}(j\omega) - R_{zelle}(j\omega)*N. \qquad (4)$$

Die Gleichungen (3) und (4) sind dabei nur eine besondere Ausgestaltung der Gleichungen (1) und (2), die für die Messung über beliebige Einzelzellen gelten. Die Vermessung des gesamten Packs wird insbesondere durch den geringen Widerstand der Zellen bei der Resonanzfrequenz möglich, da dadurch statistische Schwankungen der Zellwiderständen gegenüber den niederohmigen Verbinderwiderständen eine geringere Auswirkung aufweisen. Auch bei der Messung über zwei benachbarten Einzelzellen kann der vorbekannte Innenwiderstand subtrahiert werden. Allerdings spielt hier die statische Schwankung des Innenwiderstandes eine größere Rolle.

Da bei der Resonanzfrequenz der Zellwiderstand rein ohmsch ist, kann $R_{Kon\text{-}takt/verbinder}$ hinsichtlich Real- und Imaginärteil analysiert werden, um neben dem ohmschen Widerstand der Verbinder parasitäre Induktivitäten oder Kapazitäten der Verbindung aufzuspüren.

Das Verfahren kann zur Bandendeprüfung direkt nach Montage von Batteriepacks oder Batteriemodulen angewendet werden.

Es eignet sich aber z.B. auch für die Vermessung der Kontaktwiderstände durch das BMS eines Hybrid- oder Elektrofahrzeugs im Betrieb, um Alterung der Verbindungen aufzuspüren.

**Patentansprüche**

1.  Verfahren zur Ermittlung von Kontakt- und Verbinderwiderständen in einem Batteriepack, welches aus einer Mehrzahl von N miteinander verbundener einzelner Batteriezellen besteht, umfassend die Schritte:

    (S1) Kontaktierung der ersten und letzten Einzelzellen des Batteriepacks,
    (S2) Einprägung eines Wechselstromes ($I(j\omega)$) bei einer Untersuchungsfrequenz (w) auf die Kontakte, wobei die Untersuchungsfrequenz ($\omega$) die Resonanzfrequenz der Batteriezellen ist,
    (S3) Messung der Spannungsabfälle ($U(j\omega)$) zwischen den Kontakten, und
    Ermittlung des aus eingeprägtem Strom ($I(j\omega)$) und gemessenem Spannungsabfall ($U(j\omega)$) ermittelten Kontakt- und Verbinderwiderstands durch die folgenden Schritte:

    (S4) Ermittlung des Messwiderstandes ($R_{mess}(j\omega)$) aus dem gemessenen Spannungsabfall ($U(j\omega)$) und dem eingeprägten Strom ($I(j\omega)$) mittels des ohmschen Gesetzes, und
    (S5) Ermittlung der Summe aus Kontakt- und Verbinderwiderständen ($R_{kontakt/verbinder}(j\omega)$) mittels Subtraktion der Summe der vorgegebenen Innenwiderstände ($R_{zelle}(j\omega)$) der N Einzelzellen von dem ermittelten Messwiderstand ($R_{mess}(j\omega)$):
    $R_{kontakt/verbinder}(j\omega) = R_{mess}(j\omega) - R_{zelle}(j\omega)*N$, wobei der ohmsche Widerstand ($R_{zelle}$) der N Zellen, über denen gemessen wurde, vorbekannt ist.

2.  Verfahren nach Anspruch 1, wobei die Untersuchungsfrequenz im Bereich von 500 Hz bis 3kHz liegt.

3.  Computerprogramm, welches alle Schritte eines Verfahrens nach einem der Ansprüche 1 oder 2 ausführt, wenn es auf einem Rechengerät abläuft.

4.  Batteriesystem, umfassend

    ein Li-Ionen-Batteriepack bestehend aus einer Mehrzahl von einzelnen Batteriezellen, und
    ein Batteriemanagementsystem für Li-Ionen Batterien, welches eingerichtet ist, ein Verfahren nach einem der Ansprüche 1 oder 2 auszuführen.

5.  Kraftfahrzeug mit einem Antriebssystem, welches ein Batteriesystem nach Anspruch 4 umfasst.

**Claims**

1.  Method for identifying contact and connector resistances in a battery pack, which consists of a plurality of N individual battery cells connected to one another, comprising the following steps:

    (S1) contact-connecting the first and last individual cells of the battery pack,
    (S2) impressing an alternating current ($I(j\omega)$) at an investigation frequency ($\omega$) onto the contacts, wherein the investigation frequency ($\omega$) is the resonant frequency of the battery cells,
    (S3) measuring the voltage drops ($U(j\omega)$) between the contacts, and
    identifying the contact and connector resistance identified from the impressed current ($I(j\omega)$) and the measured

voltage drop (U(jω)) by way of the following steps:

(S4) identifying the measurement resistance ($R_{meas}$(jω)) from the measured voltage drop (U(jω)) and the impressed current (I(jω)) by means of Ohm's law, and
(S5) identifying the sum of the contact and connector resistances ($R_{contact/connector}$(jω)) by means of subtraction of the sum of the prescribed internal resistances ($R_{cell}$(jω)) of the N individual cells from the identified measurement resistance ($R_{meas}$(jω)):
$R_{contact/connector}$(jω) = $R_{meas}$(jω) - $R_{cell}$(jω)*N, wherein the ohmic resistance ($R_{cell}$) of the N cells across which measurement is carried out is already known.

2. Method according to Claim 1, wherein the investigation frequency is in the range of 500 Hz to 3 kHz.

3. Computer program, which executes all the steps of a method according to either of Claims 1 and 2 when said program runs on a computation device.

4. Battery system, comprising
an Li-ion battery pack consisting of a plurality of individual battery cells, and
a battery management system for Li-ion batteries, which is configured to execute a method according to either of Claims 1 and 2.

5. Motor vehicle comprising a drive system, which comprises a battery system according to Claim 4.

## Revendications

1. Procédé permettant de déterminer des résistances des contacts et des connecteurs dans un bloc-batterie qui est composé d'une pluralité de N éléments de batterie individuels reliés les uns aux autres, comprenant les étapes suivantes :

(S1) la mise en contact des premier et dernier éléments individuels du bloc-batterie,
(S2) l'application sur les contacts d'un courant alternatif (I(jω)) à une fréquence d'analyse (ω), dans lequel la fréquence d'analyse (ω) est la fréquence de résonance des éléments de la batterie,
(S3) la mesure des baisses de tension (U(jω)) entre les contacts, et
la détermination de la résistance des contacts et des connecteurs résultant du courant appliqué (I(jω)) et de la baisse de tension mesurée (U(jω)), par les étapes suivantes :

(S4) la détermination de la résistance de mesure ($R_{mess}$(jω)) à partir de la baisse de tension mesurée (U(jco)) et du courant appliqué (I(jω)) conformément à la loi ohmique, et
(S5) la détermination de la somme des résistances des contacts et des connecteurs ($R_{kontakt/verbinder}$(jω)) au moyen de la soustraction de la somme de la résistance interne prédéterminée ($R_{zelle}$(jω)) des N éléments individuels à la résistance de mesure déterminée ($R_{mess}$(jω)) :
$R_{kontakt/verbinder}$(jω) = $R_{mess}$(jω) - $R_{zelle}$(jω)*N, où la résistance ohmique ($R_{zelle}$) des N éléments sur lesquels la mesure a été effectuée est connue à l'avance.

2. Procédé selon la revendication 1, dans lequel la fréquence d'analyse est comprise entre 500 Hz et 3 kHz.

3. Programme d'ordinateur qui effectue toutes les étapes d'un procédé selon l'une des revendications 1 ou 2 lorsqu'il est exécuté sur un dispositif informatique.

4. Système de batterie comprenant un bloc-batterie Li-ion constitué d'une pluralité d'éléments de batterie individuels, et un système de gestion de batterie pour batteries Li-ion, qui est conçu pour mettre en oeuvre un procédé selon l'une des revendications 1 ou 2.

5. Véhicule automobile comportant un système de propulsion qui comprend un système de batterie selon la revendication 4.

1

3  4  5

**Fig. 1**

2  2

2

**Fig. 2**

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2009035658 A
- US 4697134 A